Europäisches Patentamt

European Patent Office

Office européen des brevets

(19)

(11) Veröffentlichungsnummer: **0 394 506 B1**

(12) **EUROPÄISCHE PATENTSCHRIFT**

(45) Veröffentlichungstag der Patentschrift: **22.06.94**

(51) Int. Cl.5: **G11C 27/02**

(21) Anmeldenummer: **89107375.1**

(22) Anmeldetag: **24.04.89**

(54) **Schnelle Abtast-Halte-Schaltungsanordnung.**

(43) Veröffentlichungstag der Anmeldung:
**31.10.90 Patentblatt 90/44**

(45) Bekanntmachung des Hinweises auf die
Patenterteilung:
**22.06.94 Patentblatt 94/25**

(84) Benannte Vertragsstaaten:
**AT BE CH DE FR GB IT LI LU NL SE**

(56) Entgegenhaltungen:
**GB-A- 2 083 723**
**US-A- 4 302 689**
**US-A- 4 634 993**

(73) Patentinhaber: **SIEMENS AKTIENGESELL-SCHAFT**
**Wittelsbacherplatz 2**
**D-80333 München(DE)**

(72) Erfinder: **Astegher, Berthold**
**Hauptplatz 7**
**A-9500 Villach(AT)**
Erfinder: **Jessner, Hermann**
**Neubaugasse 28/5**
**A-9500 Villach(AT)**
Erfinder: **Lechner, Alexander**
**Dietrichsteinstrasse 27**
**A-9583 Faak/See(AT)**

**Beschreibung**

Die Erfindung betrifft eine Schaltungsanordnung nach dem Oberbegriff des Patentanspruchs 1.

Abtast-Halte-Schaltungen (Sample & Holde bzw. Track & Hold) werden vor allem für Analog-Digital-Umsetzer benötigt, um für die Dauer des Umsetzvorganges einer analogen Eingangsspannung zu einem digitalen Ausgangswort die Eingangsspannung konstant zu halten und somit Fehler auszuschließen. Eine Abtast-Halte-Schaltung (S/H) tastet also ein analoges Spannungssignal zu bestimmten Zeitpunkten ab und hält den momentanen Spannungswert während der Haltephase in analoger Form konstant.

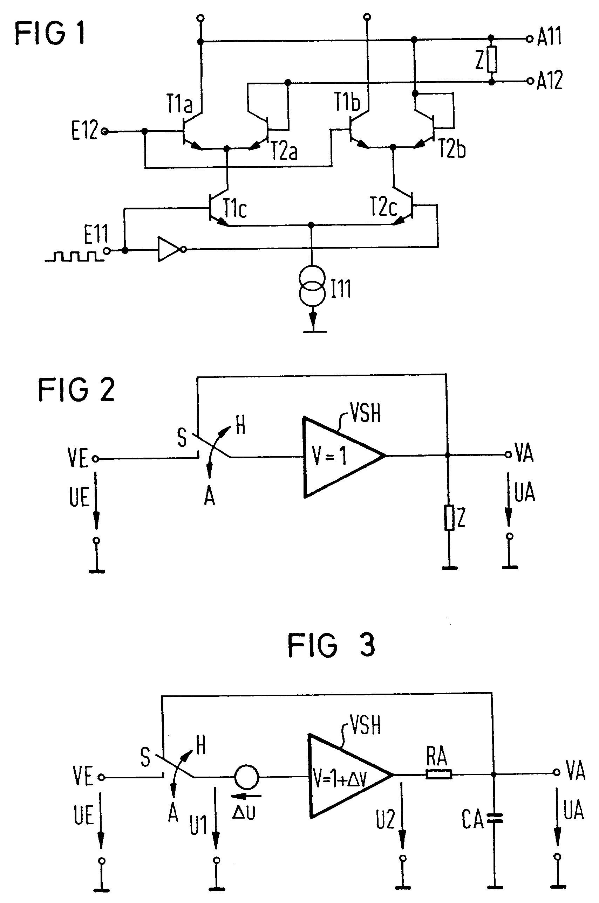

Aus der Veröffentlichung von Tanaka et. al. "A 40 MS/s Monolithic S/H IC", ISSCC 83 p. 190 ist eine Abtast-Halte-Schaltung bekannt, deren Prinzip in Fig. 3 wiedergegeben ist. Ein über einen Schalter S mit einer Eingangsklemme VE verbundener Kondensator CA wird bei geschlossenem Schalter, Stellung A, auf eine Spannung aufgeladen, die proportional oder gleich der Eingangsspannung UE ist. Während der Haltephase, Stellung H des Schalters S, wird die Spannung am Kondensator CA mit Hilfe des Verstärkers VSH hochohmig abgefühlt und steht an der Ausgangsklemme VA des Verstärkers, bezogen auf eine Bezugsklemme, als Ausgangsspannung UA zur Verfügung.

Der Schalter S muß von einem möglichst niederohmigen Zustand während der Abtastphase A, um den Kondensator C rasch umladen zu können, in einen möglichst hochohmigen Zustand während der Haltephase H umgeschaltet werden, um den mit Hilfe des Kondensators CA gespeicherten Spannungswert nicht zu beeinflussen. Ausführungen von Abtast-Halte-Schaltungen arbeiten im Frequenzbereich bis ca. 10MHz mit Feldeffekt-Transistoren.

Schnellere Abtast-Halte-Verstärker erfordern aufwendige Schaltungen mit Feldeffekt- und Bipolartransistoren beider Leitungstypen und sind in monolithisch integrierter Form kaum bekannt. Der integrierte Schaltkreis gemäß der vorgenannten Veröffentlichung arbeitet bis zu einer Abtastfrequenz von 40 MHz.

Während der Haltephase tritt bei Abtast-Halte-Schaltungen das Problem auf, daß die Spannung, die von einem Kondensator gehalten wird, mit Hilfe eines Verstärkers gefühlt wird und hierbei über den endlichen Eingangswiderstand dieses Verstärkers Ladungen abfließen, was zu einem Absenken der über dem Kondensator anliegenden Spannung führt. Um einen störungsfreien Betrieb zu gewährleisten, ist also als Haltekapazität eine Kapazität erforderlich, die nicht allzu klein sein darf und somit die Arbeitsgeschwindigkeit der AbtastHalte-Schaltung begrenzt.

Aus dem Artikel "Applications of a Four-quadrant-multiplier" von C.R. Ryan in IEEE Journal of Solid State Circuits, Feb. 1970, Seiten 45-48 ist eine Abtast-Halte-Schaltung bekannt, bei der die Verstärkungsabweichung eines rückgekoppelten Verstärkers die Haltezeit beeinflußt.

FIG 2 zeigt eine solche bekannte Schaltung mit einem Signaleingang, einem Steuereingang und einer Rückkoppelschaltung.

Aus der US-A-3,452,289 ist eine Signalverarbeitungseinheit bekannt, die folgende Kombination enthält: Einen ersten Differenzverstärker mit einem ersten und einem zweiten Halbleiterbauelement (beispielsweise einem fünften und sechsten Transistor T1c, T2c mit zusammengeschalteten Emittern, wobei jedes dieser Halbleiterbauelemente einen Steuereingang zum Empfangen eines ersten Eingangssignales sowie einen Kollektoranschluß aufweist, einen zweiten und einen dritten Differenzverstärker, die jeweils aus einem dritten und einem vierten bzw. einem fünften und einem sechsten Halbleiterbauelement (beispielsweise einem ersten, zweiten, dritten und vierten Transistor T1a, T1b, T2a, T2b) bestehen, wobei jedes Halbleiterbauelement einen Kollektor aufweist, einen Steuereingang besitzt und einen Emitter aufweist, wobei die Emitteranschlüsse der Transistoren in dem zweiten und im dritten Differenzverstärker jeweils zusammengeschaltet sind und jeweils an den Kollektor des ersten bzw. des zweiten Halbleiterbauelementes T1c, T2c angeschlossen sind, die Steuereingänge des dritten und des fünften Halbleiterbauelementes T1a, T1b sind zum Empfangen eines zweiten Eingangssignales zusammengeschaltet, die Kollektoranschlüsse des dritten und des sechsten Halbleiterbauelementes T1a, T2b sind zusammengeschaltet und bilden eine erste Ausgangsklemme A11, die Kollektoranschlüsse des vierten und des fünften Halbleiterbauelementes T2a, T1b sind ebenfalls zusammengeschaltet und bilden eine zweite Ausgangsklemme A12, die erste Ausgangsklemme A11 ist über Schaltmittel Z mit der zweiten Ausgangsklemme A12 verbunden und die erste Ausgangsklemme A11 ist an den Steuereinang des sechsten Halbleiterbauelements T2b geschaltet und die zweite Ausgangsklemme A12 ist an den Steuereingang des vierten Halbleiterbauelementes T2a geschaltet und die Steuereingänge des ersten und des zweiten Halbleiterbauelementes T1c, T2c sind derart mit dem ersten Eingangssignal E11 beaufschlagt, daß diese beiden Halbleiterbauelemente alternierend einen Strom leiten oder sperren.

Figur 1 zeigt eine solche bekannte Schaltung.

Bei solchen bekannten Schaltungen wird zwischen der Abtast- und der Halte-Phase dadurch umgeschaltet, daß der Strom in den einzelnen Strompfaden der Abtast-Halte-Verstärkerschaltung umgeschaltet wird, d.h., daß der Strom durch den in der Abtastphase aktivierten Strompfad abgeschaltet wird und der Strom durch den anderen, in der Haltephase aktivierten Strompfad eingeschaltet wird. Werden solche bekannten Schaltungen so ausgeführt, daß sie mit differentiellen (symmetrischen) Signalen arbeiten, so fließen in der Abtast-Phase unterschiedlich große Ströme in den unterschiedlichen Strompfaden des Abtast-Halte-Verstärkers. Wenn zwischen der Abtast-und der Haltephase umgeschaltet wird, indem die Ströme umgeschaltet werden, d.h. eingeschaltet bzw. abgeschaltet werden, so führen die durch die Ansteuerung am Signaleingang bedingten unterschiedlich großen Ströme zu einem unterschiedlichen Schaltverhalten. Das führt zu Signalsprüngen am Ausgang der Abtast-Halte-Schaltung.

Aufgabe der Erfindung ist es, ein Abtast-Halte-Glied zum Verarbeiten differentieller Signale anzugeben, das beim Umschalten von der Abtast- in die Haltephase keine Signalsprünge am Ausgang verursacht und somit eine kleinere Halte-Kapazität bzw. eine größere Verarbeitungsgeschwindigkeit ermöglicht.

Diese Aufgabe wird erfindungsgemäß durch eine Schaltungsanordnung nach dem Patentanspruch 1 gelöst.

Besonders günstige Ausführungsformen erfindungsgemäßer Schaltungsanordnungen sind Gegenstand von Unteransprüchen.

Die erfindungsgemäße Schaltungsanordnung besitzt den Vorteil, daß zur Speicherung der abgetasteten Analogspannung metastabile Zustände des Verstärkers ausgenutzt werden, so daß die Schaltungsanordnung im Idealfall ohne weiteres Stabilisierungsnetzwerk betrieben werden kann.

Um die Erfindung näher zu erläutern, wird im Folgenden vorab das Grundprinzip der in erfindungsgemäßen Schaltungen verwendeten Abtast-Halte-Schaltungen anhand von in den Figuren 1 bis 6 der Zeichnung dargestellten Ausführungsbeispielen näher erläutert. Dabei sind gleiche Elemente mit gleichen Bezugszeichen versehen. Es zeigt:

| Figur 1 | ein Schaltbild einer bekannten Abtast-Halte-Schaltung, |
|---|---|
| Figur 2 | ein schematisches Schaltbild einer bekannten, für erfindungsgemäße Schaltungen wichtigen Abtast-Halte-Schaltung, |
| Figur 3 | ein schematisches Ersatzschaltbild einer Abtast-Halte-Schaltungsanordnung gemäß Figur 2 unter Berücksichtigung physikalischer Störgrößen, |
| Figur 4 | eine Abtast-Halte-Schaltungsanordnung gemäß Figur 3 mit umschaltbaren Ausgangszeitkonstanten, |
| Figur 5 und Figur 6 | zwei Diagramme zur Abschätzung der Genauigkeitsanforderungen an eine Abtast-Halte-Schaltungsanordnung. |
| Figur 7 | eine erfindungsgemäße Abtast-Halte-Schaltungsanordnung mit einer möglichen Ausführungsform einer Pegelschiebereinrichtung. |
| Figur 8 | eine besonders günstige Ausführungsform eines erfindungsgemäßen Abtast-Halte-Verstärkers sowie eine besonders günstige Ausführungsform von Pegelschiebereinrichtungen. |

Die Schaltungsanordnung gemäß Figur 2 nutzt metastabile Zustände des Verstärkers VSH aus, um eine mit Hilfe des Schalters S abgetastete analoge Eingangsspannung UE für eine bestimmte Zeitdauer bzw. während der Haltephase H konstant zu halten. Dabei liegt der Schalter S verstärkerseitig nur am Eingang des Verstärkers VSH, dessen Verstärkung V genau 1 betragen muß. Während der Haltephase H wird der Verstärkerausgang bzw. die Ausgangsklemme VA über den Schalter S direkt auf den Verstärkereingang rückgekoppelt.

Gemäß dem Ausführungsbeispiel nach Figur 2 ist von der Ausgangsklemme VA zur nichtbezeichneten Bezugsklemme ein komplexes Stabilisierungsnetzwerk Z vorgesehen, das im einfachsten Fall aus einem Kondensator bestehen kann. Bei idealen Bedingungen für die Abtast-Halte-Schaltungsanordnung kann das komplexe Stabilisierungsnetzwerk Z weggelassen werden, ohne daß sich die Ausgangsspannung UA in der Haltephase verändern würde. Unter Berücksichtigung realer physikalischer Verhältnisse muß für den Verstärker VSH ein Offset $\Delta u$ und eine Abweichung des Verstärkungsfaktors V vom Idealwert 1 um den Wert $\Delta v$ berücksichtigt werden. Fig. 3 zeigt das physikalische Ersatzschaltbild der realen Abtast-Halte-Schaltungsanordnung gemäß Figur 2. Der Offset des Verstärkers VSH ist als Spannungsquelle mit der Spannung $\Delta u$ zwischen dem Schalter 5 und dem Eingang des Verstärkers VSH eingezeichnet.

Die Verstärkung V des Verstärkers VSH beträgt gemäß Figur 3 dann $1 + \Delta v$. Der real von 0 verschiedene Ausgangswiderstand des Verstärkers VSH ist als Widerstand RA zwischen dem Ausgang des Verstärkersymbols und der Ausgangsklemme VA eingezeichnet.

Im Ausführungsbeispiel gemäß Figur 3 ist für das Stabilisierungsnetzwerk Z zwischen der Ausgangsklemme VA der Schaltungsanordnung und demem Bezugspotential ein Stabilisierungskondensator CA vorgesehen. Entsprechend Figur 2 ist die Ausgangsklemme VA mit dem Schalter S verbunden und somit während der Haltephase H auf den Verstärkereingang rückgekoppelt.

Während der Abtastphase ist unter der Annahme, daß die Störgrößen $\Delta u$ und $\Delta v$ gleich Null sind, die 3 dB-Grenz-Kreisfrequenz gleich dem reziproken Produkt aus dem Ausgangswiderstand RA und dem Kondensator CA.

Das Verhalten der Schaltungsanordnung gemäß Figur 3 während der Haltephase, insbesondere die Dauer der metastabilen Zustände läßt sich unter Einführung der Spannungen U1 vom verstärkerseitigen Anschluß des Schalters S und U2 zwischen dem Verstärker VSH und dem Ausgangswiderstand RA, jeweils bezogen auf eine Klemme mit Bezugspotential, gemäß folgender Formeln berechnen:

$$U2 = (U1 + \Delta u) \cdot (1 + \Delta v)$$

$$\frac{dUA}{dt} = \frac{1}{CA} \cdot i_c(t) = \frac{U2(t) - UA(t)}{RA \quad CA}$$

$$U1 = UA$$

Damit ergibt sich folgende Differentialgleichung:

$$\frac{dUA}{dt} - \frac{\Delta v}{RA \quad CA} \cdot UA = \frac{\Delta u}{RA \quad CA} \cdot (1 + \Delta v).$$

Die allgemeine Lösung der Differentialgleichung lautet:

$$UA(t) = (UAo + \Delta u \cdot \frac{1 + \Delta v}{\Delta v} Y) \cdot \exp\left(\frac{\Delta v \cdot t}{RA \quad CA}\right) - \Delta u \frac{1 + \Delta v}{\Delta v}$$

wobei UAo der Spannungswert zu Beginn der Haltephase ist.

Vereinfachte Lösungen der allgemeinen Lösung der Differentialgleichung gibt es für die Spezialfälle, daß jeweils eine der Störgrößen $\Delta u$ bzw. $\Delta v$ gleich Null sind. Man erhält für $\Delta u$ gleich Null:

$$UA(t) = UAo \cdot \exp\left(\frac{\Delta v \cdot t}{RA \cdot CA}\right)$$

sowie für den Spezialfall $\Delta v$ gleich Null:

$$UA(t) = UAo + \frac{\Delta u \cdot t}{RA \cdot CA}$$

Aus den vereinfachten Lösungen der Differantialgleichung ist zu erkennen, daß der metastabile Zustand der Abtast-Halte-Schaltungsanordnung um so schneller verlassen wird, je größer die Störgrößen $\Delta u$ und $\Delta v$ sind. Für den Fall $\Delta u$ gleich Null ergibt sich eine exponentielle Änderung der Ausgangsspannung UA mit zunehmender Zeit t, während für den Fall $\Delta v$ gleich Null zum Spannungswert zu Beginn der Abtastphase ein mit der Zeit linear wachsender additiver Term hinzukommt.

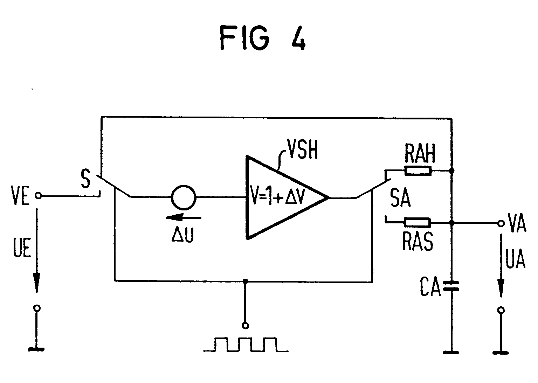

Im Ausführungsbeispiel gemäß Figur 4 ist am Ausgang des Verstärkers VSH ein zusätzlicher Schalter SA vorgesehen, der je nach Stellung einen Ausgangswiderstand RAH oder einen Ausgangswiderstand RAS in den Signalweg schaltet, wobei RAH größer als RAS gewählt wird. Damit wird die Ausgangszeitkonstante RAH·CA für die Haltephase größer als jene für die Abtastphase.

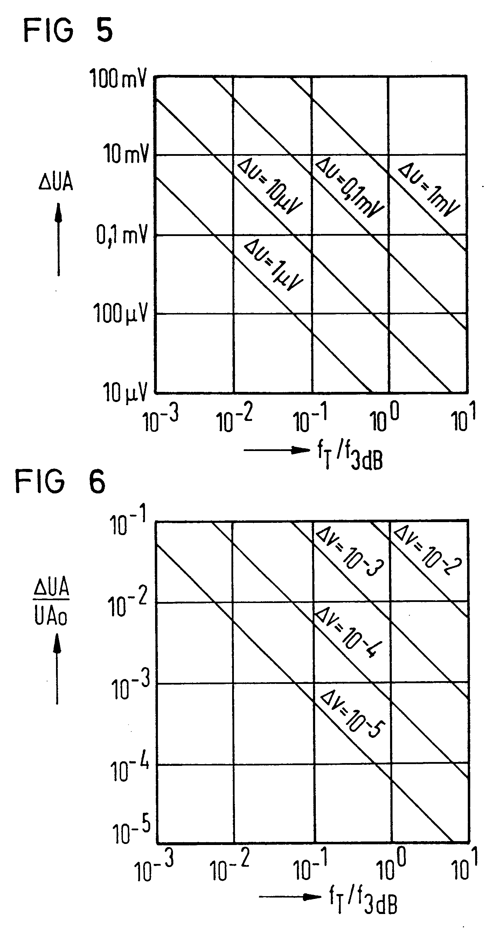

Die an eine erfindungsgemäße Abtast-Halte-Schaltungsanordnung zu stellenden Genauigkeitsanforderungen sind in den Diagrammen gemäß Figur 5 und Figur 6 dargestellt. In beiden Diagrammen ist auf der Abszisse die Abtastfrequenz $f_T$ bezogen auf die 3 dB-Grenzfrequenz abgetragen. Fig. 5 gibt als Ordinatenwert die Änderung $\Delta UA$ der Ausgangsspannung als Differenz des Wertes UAo der Ausgangsspannung zu Beginn der Haltephase und des Spannungswertes UA(T) nach der Zeit (T) an, die gleich der inversen Abtastfrequenz $f_T$ ist.

Als Parameter sind in Figur 5 dekadisch unterschiedliche Werte für die Störgröße $\Delta u$ eingetragen. Figur 6 zeigt auf der Ordinate die oben definierte Änderung $\Delta UA$ der Ausgangsspannung als Relativgröße, bezogen auf den Wert UAo der Ausgangsspannung zu Beginn der Haltephase und als Parameter verschiedene dekadisch gestufte Werte für die Störgröße $\Delta v$ in der Abweichung des Verstärkungsfaktors des Verstärkers VSH vom Idealwert 1.

Aus den Figuren 5 und 6 ist zu entnehmen, daß bei Störgrößen $\Delta u$ und $\Delta v$, die mit hochpräzisen monolithisch integrierten Verstärkern erreicht werden können, bei einer Abtastfrequenz $f_T$, die etwa der 3 dB-Grenzfrequenz entspricht, d.h. um den Abszissenwert $10^0$, noch eine hohe Genauigkeit der erfindungsgemäßen Abtast-Halte-Schaltungsanordnung zu erzielen ist. Die erreichbare Genauigkeit kann durch die Wahl unterschiedlicher Zeitkonstanten für die Abtast- bzw. Haltephase gemäß dem Schaltungsbeispiel nach Figur 4 weiter erhöht werden. Damit besitzt eine solche erfindungsgemäße Abtast-Halte-Schaltungsanordnung den Vorteil, daß sie sich sogar für den Einsatz in monolithischen Analog-Digital-Umsetzern eignet, die nahe der Nyquistfrequenz betrieben werden.

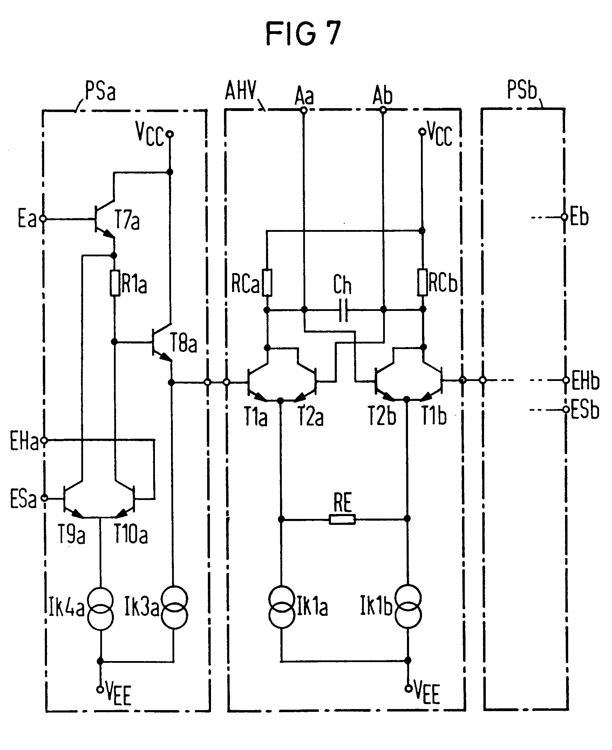

Figur 7 zeigt eine Schaltungsanordnung mit einem symmetrisch aufgebauten Abtast-Halte-Verstärker AHV, bestehend aus einem ersten Transistor T1a, einem zweiten Transistor T1b, einem dritten Transistor T2a und einem vierten Transistor T2b, wobei der Kollektor des ersten Transistors T1a mit dem Kollektor des dritten Transistors T2a zusammengeschaltet ist und die erste Ausgangsklemme Aa bildet und der Kollektor des zweiten Transistors T1b mit dem Kollektor des vierten Transistors T2b zusammengeschaltet ist und die zweite Ausgangsklemme Ab bildet, wobei die erste Ausgangsklemme Aa über einen ersten Kollektorwiderstand RCa an ein erstes Versorgungspotential $V_{CC}$ geschaltet ist und die zweite Ausgangsklemme Ab über einen zweiten Kollektorwiderstand RCb ebenfalls an dieses erste Versorgungspotential $V_{CC}$ geschaltet ist, wobei die erste Ausgangsklemme Aa mit den Steuereingang des vierten Transistors T2b verbunden ist und die zweite Ausgangsklemme Ab mit dem Steuereingang des dritten Transistors T2a verbunden ist, wobei die erste und die zweite Ausgangsklemme Aa, Ab über eine Haltekapazität Ch miteinander verbunden sind, wobei der Emitter des ersten Transistors T1a mit dem Emitter des dritten Transistors T2a unmittelbar verbunden ist und der Emitter des zweiten Transistors T1b mit dem Emitter des vierten Transistors T2b unmittelbar verbunden ist, wobei die Emitter des ersten und des dritten Transistors T1a, T2a und die Emitter des zweiten und des vierten Transistors T1b, T2b über mindestens einen Widerstand RE, REa, REb miteinander verbunden sind und über mindestens eine Konstantstromeinprägung Ik1, Ik1a, Ik1b an ein zweites Versorgungspotential $V_{EE}$ geschaltet sind und wobei der Steueranschluß des ersten Transistors T1a und der Steueranschluß des zweiten Transistors T1b mit einem differentiellen Signal beaufschlagbar sind, wobei erfindungsgemäß die erste Signaleingangsklemme Ea den Eingang einer ersten schaltbaren Pegelschiebereinrichtung PSa bildet, die zweite, für das zum an der ersten Signaleingangsklemme Ea eingespeiste Signal komplementäre Signal vorgesehene Signaleingangsklemme Eb den Eingang einer zweiten schaltbaren Pegelschiebereinrichtung PSb bildet, der Ausgang der ersten schaltbaren Pegelschiebereinrichtung PSa mit dem Steueranschluß des ersten Transistors T1a zusammengeschaltet ist, der Ausgang der zweiten schaltbaren Pegelschiebereinrichtung PSb mit dem Steueranschluß des zweiten Transistors T1b zusammengeschaltet ist und zwischen dem Eingangssignal und dem Ausgangssignal dieser steuerbaren Pegelschiebereinrichtungen PSa, PSb in Abhängigkeit vom Schaltzustand der Pegelschiebereinrichtungen eine unterschiedliche, jeweils konstante Gleichspannungsdifferenz besteht.

Ein Merkmal der Erfindung ist darin zu sehen, daß das abzutastende Signal über eine schaltbare Pegelschiebereinrichtung (Levelshifter) derart aufbereitet wird, daß das Ausgangssignal dieser Pegelschiebereinrichtung aus dem Eingangssignal der Pegelschiebereinrichtung und einem additiven, konstanten Gleichspannungsanteil gebildet ist und der additive, konstante Gleichspannungsanteil je nach Schaltzustand der Pegelschiebereinrichtung mindestens zwei verschiedene Werte annimmt. Von diesen zwei verschiedenen Werten des additiven Gleichspannungsanteils des Ausgangssignales der Pegelschiebereinrichtung kann einer gleich Null sein. In den später noch beschriebenen Ausführungsbeispielen von Pegelschiebereinrichtungen handelt es sich jedoch üblicherweise um zwei verschieden große konstante Gleichspannungsanteile mit negativem Vorzeichen. Die Ausgangsgröße der Pegelschiebereinrichtung PSa sollte einerseits so ausgelegt sein, daß in der einen Schaltstellung dieser Pegelschiebereinrichtung PSa der von ihrem Ausgangssignal angesteuerte erste Transistor T1a des Abtast-Halte-Verstärkers AHV beim kleinsten, am Eingang Ea der Pegelschiebereinrichtung PSa zu verarbeitenden Signal noch sicher leitet und der dritte Transistor T2a noch sicher sperrt, andererseits sollte in der anderen Schaltstellung der Pegelschiebereinrichtung PSa der von ihrem Ausgangssignal angesteuerte erste Transistor T1a beim größten, am Eingang Ea der Pegelschiebereinrichtung zu verarbeitenden Signal noch sicher sperren und der dritte Transistor T2a noch sicher leiten.

Zur Verarbeitung differentieller Signale wird der Eingang Ea der ersten Pegelschiebereinrichtung PSa mit einem Signalanteil beaufschlagt und der Eingang Eb der zweiten Pegelschiebereinrichtung PSb wird mit dem hierzu komplementären Signalanteil beaufschlagt. Die Steuerung der verschiedenen Schaltzustände der ersten und der zweiten Pegelschiebereinrichtung PSa, PSb muß so gekoppelt sein, daß an den Ausgängen beider Pegelschiebereinrichtungen PSa und PSb gleichzeitig ein relativ zu ihrem Eingangssignal hoher oder niedriger Spannungspegel anliegt, d.h., der additive Anteil der Ausgangssignale muß in beiden Pegelschiebereinrichtungen gleichzeitig gleich groß sein.

Haben die Pegelschiebereinrichtungen relativ hohe Ausgangspegel, so wird das Ausgangssignal des Abtast-Halte-Verstärkers AHV durch das Differenzverstärker-Transistorpaar T1a, T1b bestimmt. Werden durch Umschalten der Pegelschiebereinrichtung PSa und PSb die Potentiale an den Steuereingängen des ersten und des zweiten Transistors T1a, T1b um einen bestimmten Gleichspannungsanteil abgesenkt, so sperren der erste und der zweite Transistor T1a und T1b. Gleichzeitig leiten jedoch der dritte und der vierte Transistor T2a und T2b und da der dritte und der vierte Transistor T2a und T2b von dem durch den ersten und zweiten Transistor T1a, T1b an die Ausgangsklemmen Aa und Ab gegebenen Signal angesteuert werden, führt der dritte Transistor T2a den Strom, der vorher durch den ersten Transistor geflossen ist und der vierte Transistor T2b führt den Strom, der vorher durch den zweiten Transistor T1b geflossen ist. Die Abtastphase bei einer erfindungsgemäßen Abtast-Halte-Schaltungsanordnung ist dann gegeben, wenn das Ausgangssignal der ersten Pegelschiebereinrichtung PSa größer ist als das Signal an der Ausgangsklemme Ab des Abtast-Halte-Verstärkers AHV und wenn das Signal am Ausgang der zweiten Pegelschiebereinrichtung PSb größer ist als das Signal an der Ausgangsklemme Aa des Abtast-Halte-Verstärkers AHV. Eine erfindungsgemäße Schaltungsanordnung ist in der Haltephase, wenn das Signal an der Ausgangsklemme Ab größer ist als das Signal am Ausgang der ersten Pegelschiebereinrichtung PSa und wenn das Signal an der Ausgangsklemme Aa größer ist als das Signal am Ausgang der zweiten Pegelschiebereinrichtung PSb.

Weil sowohl die Kollektorkreisbeschaltung und die Emitterkreisbeschaltung des ersten und des dritten Transistors T1a, T2a bzw. des zweiten und des vierten Transistors T1b, T2b als auch die Konstantstromeinprägung Ik1, Ik1a, Ik1b identisch sind und auch kein Strom innerhalb des Abtast-Halte-Verstärkers geschaltet wird, bleibt das Ausgangssignal erfindungsgemäßer Abtast-Halte- Schaltungsanordnungen beim Umschalten vom Abtast- in den Halte- Modus gleich. Es treten keine durch das Umschalten bedingte Stromüberhöhungen im Abtast-Halte-Verstärker und somit auch keine Signalsprünge an den Ausgangsklemmen Aa und Ab auf.

Da das Ausgangssignal des Abtast-Halte-Verstärkers in der Halte-Phase von dem Differenzsignal abhängt, das zwischen den Ausgangsklemmen Aa und Ab liegt, hat ein gleichzeitiges Absinken des Signalpegels an beiden Ausgangsklemmen Aa und Ab um einen bestimmten Gleichspannungsanteil keinen Einfluß auf das Signal.

Wenn, wie aus den vorherigen Erläuterungen zu entnehmen ist, der Verstärkungsfaktor eines erfindungsgemäßen Abtast-Halte-Verstärkers möglichst genau 1 ist, kann eine solche Schaltung mit einer geringen Haltekapazität Ch auskommen, was zu einer sehr hohen Verarbeitungsfrequenz führt.

Ein solcher Verstärker wird dadurch erreicht, daß im Kollektorkreis und im Emitterkreis jeweils das gleiche Strom- und Spannungsverhalten erzielt wird. Hierzu sollten die Widerstände RCa, REa, RCb und REb möglichst gleich groß sein bzw. der Widerstand RE so groß wie die Summe der Widerstände RCa und RCb.

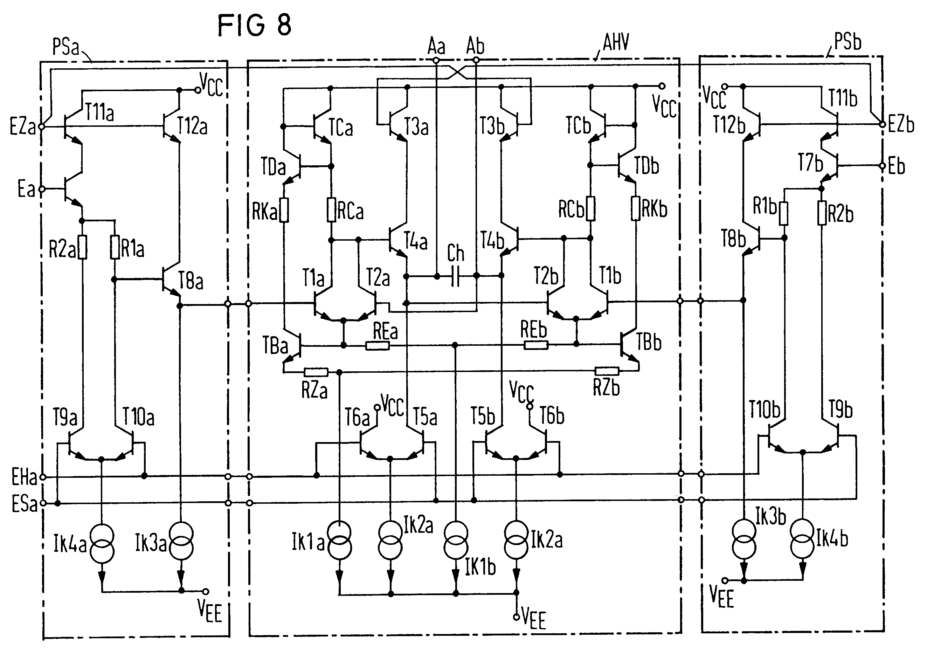

Figur 8 zeigt eine Schaltung, die eine Realisierung des Verstärkungsfaktors 1 ermöglicht. Die in Figur 8 gezeigte Abtast-Halte-Verstärkerschaltung AHV unterscheidet sich von der Schaltung nach Figur 7 vor allem darin, daß der Emitteranschluß des ersten Transistors T1a unmittelbar mit dem Emitteranschluß des dritten Transistors T2a, dem Basisanschluß eines neunten Transistors TBa und einem Anschluß eines ersten Emitterwiderstandes REa zusammengeschaltet ist, daß der Emitteranschluß des zweiten Transistors T1b unmittelbar mit dem Emitteranschluß des vierten Transistors T2b, dem Basisanschluß eines zehnten TBb und mit einem Anschluß eines zweiten Emitterwiderstandes REb zusammengeschaltet ist, daß die beiden Emitterwiderstände REa, REb mit ihrem jeweils anderen Anschluß über eine Konstantstromeinprägung Ik1 an das zweite Versorgungspotential $V_{EE}$ geschaltet sind, daß der Emitteranschluß des neunten Transistors TBa über die Serienschaltung zweier zusätzlicher Widerstände RZa, RZb mit dem Emitteranschluß des zehnten Transistors TBb verbunden ist, daß der Schaltungsknoten, der die beiden zusätzlichen Widerstände RZa, RZb verbindet, über eine weitere Konstantstromeinprägung Ik1c an das zweite Versorgungspotential $V_{EE}$ geschaltet ist, daß der Kollektoranschluß des neunten Transistors TBa über einen Widerstand (RKa) an das erste Versorgungspotential $V_{CC}$ geschaltet ist und daß der Kollektoranschluß des zehnten Transistors TBb ebenfalls über einen Widerstand RKb an das erste Versorgungspotential $V_{CC}$ geschaltet ist. Außerdem ist das erste Versorgungspotential $V_{CC}$ jeweils über eine in Durchlaßrichtung geschaltete Diode TCa, TCb an den ersten bzw. zweiten Kollektorwiderstand RCa, RCb geschaltet, wobei als Diodenstrecke jeweils ein Transistor TCa, TCb vorgesehen ist, dessen Kollektoranschluß mit dem Basisanschluß kurzgeschlossen ist und die Emitteranschlüsse dieser Transistoren TCa, TCb jeweils mit dem Basisanschluß eines elften Transistors TDa bzw. zwölften Transistors TDb verbunden sind, wobei der Kollektoranschluß des elften Transistors TDa und der Kollektoranschluß des zwölften Transistors TDb jeweils unmittelbar mit dem ersten Versorgungspotential $V_{CC}$ beaufschlagt ist, wobei der Emitteranschluß des elften Transistors TDa über einen Widerstand RKa an den Kollektoranschluß des neunten Transistors TBa angeschlossen ist und wobei der Emitteranschluß des zwölften Transistors TDb über einen Widerstand RKb an den Kollektoranschluß des zehnten Transistors TBb angeschlossen ist. Um den Verstärkungsfaktor Eins zu erzielen sollten die Widerstände und die Transistoren in dieser Verstärkerschaltung möglichst gleich sein.

Der Basisstrom, der dem ersten Transistor T1a oder in der Halte-Phase dem dritten Transistor T2a zugeführt wird, wird durch den neunten Transistor TBa wieder abgeführt. Dadurch fließt so wohl im Kollektorwiderstand RCa als auch im Emitterwiderstand REa der gleiche Strom. Der Spannungsabfall über die Basis-Emitter-Diode des ersten Transistors T1a bzw. des dritten Transistors T2a im Emitterkreis kann durch den Transistor TCa im Kollektorkreis ausgeglichen werden. Eine besondere Ausführungsform ist hierbei in Figur 8 gezeigt, weil der Basisstrom des Transistors TCa über den elften Transistor TDa aus dem Verstärkerkreis abgeführt wird.

Es ist empfehlenswert, daß der der Strom- und Spannungskompensation dienende Verstärker aus TDa, TDb, RKa, RKb, TBa, TBb, RZa, RZb und Ik1c identisch aufgebaut ist wie der eigentliche Abtast-Halte-Verstärkeraus TCa, TCb, RCa, RCb, T1a oder T2a, T1b oder T2b, REa, REb und Ik1.

Um den Abtast-Halte-Verstärker vor nachgeschalteten Lasten zu entkoppeln und aufgrund der für das Halteverhalten wichtigen Ausgangsimpedanz der Schaltung ist es empfehlenswert, daß, wie in Figur 8 gezeigt, die Kollektoranschlüsse des ersten und des dritten Transistors T1a, T2a nicht unmittelbar die erste Ausgangsklemme Aa bilden, sondern an den Steueranschluß eines ersten Impedanzwandlers T4a und über den ersten Kollektorwiderstand RCa an das erste Versorgungspotential $V_{CC}$ geschaltet sind, daß die Kollektoranschlüsse des zweiten und des vierten Transistors T1b, T2b nicht unmittelbar die zweite Ausgangsklemme Ab bilden, sondern an den Steueranschluß eines zweiten Impedanzwandlers T4b und über den zweiten Kollektorwiderstand RCb an das erste Versorgungspotential $V_{CC}$ angeschlossen sind, daß der Ausgang des ersten Impedanzwandlers T4a die erste Ausgangsklemme Aa bildet und daß der Ausgang des zweiten Impedanzwandlers T4b die zweite Ausgangsklemme Ab bildet. Insbesondere kann dies dadurch erreicht werden, daß der erste und der zweite Impedanzwandler jeweils durch einen siebten bzw. achten Transistor T4a, T4b in Emitterfolgerschaltung realisiert ist, wobei der Kollektoranschluß des siebten bzw. achten Transistors T4a, T4b jeweils an das erste Versorgungspotential $V_{CC}$ geschaltet ist und der Emitteranschluß des siebten bzw. achten Transistor T4a, T4b, der jeweils die erste bzw. zweite Ausgangsklemme Aa, Ab der Schaltungsanordnung bildet jeweils über eine zweite bzw. dritte Konstantstromeinprägung Ik2a, Ik2b an das zweite Versorgungspotential $V_{EE}$ geschaltet ist.

Bei einer beschriebenen Schaltung kann die Ausgangszeitkonstante dadurch beeinflußt werden, daß die zweite Konstantstromeinprägung Ik2a über einen ersten Umschalter T5a, T6a entweder an den Emitteranschluß des siebten Transistor T4a oder an ein Versorgungspotential - beispielsweise das erste Versorgungspotential $V_{CC}$ - schaltbar ist und daß die dritte Konstantstromeinprägung Ik2b über einen zweiten Umschalter T5b, T6b entweder an den Emitteranschluß des achten Transistors T4b oder an ein Versorgungspotential - beispielsweise das erste Versorgungspotential $V_{CC}$ schaltbar ist. In der Halte-Phase wird der siebte Transistor T4a dann über den ersten Umschalter T5a, T6a stromlos geschaltet und der achte Transistor T4b wird über den zweiten Umschalter T5b, T6b stromlos geschaltet, was zu einer großen Zeitkonstante führt.

Um Nichtlinearitäten, die infolge des Early-Effektes auftreten, zu verhindern, kann diese beschriebene Impedanzwandlerschaltung derart abgewandelt werden, daß zwischen dem ersten Versorgungspotential $V_{CC}$ und dem Kollektoranschluß des siebten bzw. achten Transistors T4a, T4b jeweils die steuerbare Strecke eines Transistors T3a, T3b geschaltet ist, daß der Steuereingang des am siebten Transistor T4a angeschlossenen Transistors T3a mit einem vom am Eingang Eb der zweiten Pegelschiebereinrichtung PSb anliegenden Signal abgeleiteten Signal beaufschlagt ist und daß der Steuereingang des am achten Transistor T4b angeschlossenen Transistors T3b mit einem vom am Eingang Ea der ersten Pegelschiebereinrichtung PSa anliegenden Signal abgeleiteten Signal beaufschlagt ist, wobei das Signal, mit dem der Transistor T3a beaufschlagt wird, sich von dem Signal, mit dem der Eingang Eb beaufschlagt wird, sowie das Signal, mit dem der Transistor T3b beaufschlagt wird, sich von dem Signal, mit dem der Eingang Ea beaufschlagt wird, um einen konstanten Gleichspannungsanteil unterscheidet, wobei dieser Gleichspannungsanteil so gewählt werden sollte, daß die Transistoren in den beiden Impedanzwandlerstufen nicht in Sättigung gelangen.

Als besonderes Ausführungsbeispiel einer Pegelschiebereinrichtung ist in Figur 7 beschrieben, daß der für das abzutastende Signal vorgesehene Eingang Ea der Pegelschiebereinrichtung PSa mit dem Steuereingang eines Eingangstransistors T7a verbunden ist, daß der Kollektoranschluß des Eingangstransistors T7a an das erste Versorgungspotential $V_{CC}$ geschaltet ist, daß der Emitteranschluß des Eingangstransistors T7a über mindestens einen Schiebewiderstand R1a sowohl an den Steuereingang eines Ausgangstransistors T8a, als auch an einen Wechseleingang eines dritten Umschalters T9a, T10a geschaltet ist, daß der Emitteranschluß des Eingangstransistors T7a außerdem an den anderen Wechseleingang dieses dritten Umschalters T9a, T10a geschaltet ist, daß der Zentraleingang dieses dritten Umschalters T9a, T10a über eine Konstantstromeinprägung Ik4a an das zweite Versorgungspotential $V_{EE}$ angeschlossen ist, daß der Kollektoranschluß des Ausgangstransistors T8a an das erste Versorgungspotential $V_{CC}$ geschaltet ist, daß der Emitter des Ausgangstransistors T8a den Ausgang der ersten Pegelschiebereinrichtung PSa bildet und über eine weitere Konstantstromeinprägung Ik3a an das zweite Versorgungspotential $V_{EE}$ angeschlossen ist. Aus Symmetriegründen kann hierbei auch der andere Wechseleingang des dritten Umschalters über einen Widerstand R2a an den Emitteranschluß des Eingangstransistors T7a geschaltet werden, wobei der Widerstand R2a üblicherweise gleich groß ist wie der Schiebewiderstand R1a. Der Ausgangstransistor T8a ist als Impedanzwandler geschaltet. Hier kann selbstverständlich jeder bekannte Impedanzwandler eingesetzt werden.

Eine besonders günstige Ausführungsform ergibt sich, wenn der Kollektoranschluß des Eingangstransistors T7a über die steuerbare Strecke eines weiteren Transistors T11a an das erste Versorgungspotential $V_{CC}$ geschaltet ist und wenn der Kollektoranschluß des Ausgangstransistors T8a ebenfalls über die steuerbare Strecke eines weiteren Transistors T12a an das erste Versorgungspotential $V_{CC}$ angeschlossen ist, wobei die Steuereingänge der Transistoren T11a und T12a zusammengeschaltet sind und einen zusätzlichen Signaleingang EZa der Pegelschiebereinrichtung bilden. Hierbei ist es erforderlich, daß das Signal, mit dem der Eingang EZa beaufschlagt wird, sich von dem Signal, mit dem der Eingang Ea beaufschlagt wird, um einen konstanten Gleichspannungsanteil unterscheidet, wobei dieser Gleichspannungsanteil so gewählt werden sollte, daß die Transistoren in der Pegelschiebereinrichtung nicht in Sättigung gelangen. Eine solche Schaltung ermöglicht es, Nichtlinearitäten, die infolge des Early-Effektes auftreten, zu kompensieren.

Wenn vorhergehend nur ein Teil der Gesamtschaltung beschrieben worden ist, so ist selbstverständlich, daß aufgrund des symmetrischen Aufbaus, dies jeweils auch für die andere Hälfte der Gesamtschaltung gilt. Aufgrund der Symmetrie korrespondierende Schaltungselemente unterscheiden sich in ihren Bezugszeichen hierbei durch die Buchstaben a und b. Eine Realisierung einer derartigen erfindungsgemäßen Abtast-Halte-Schaltungsanordnung ist sowohl mit Transistoren verschiedenster Typen, z.B. mit bipolaren Transistoren, MOSFETs, MISFETs oder MESFETs als auch in verschiedenen Technologien, z.B. in Si-, GaAs-Technologie oder anderen möglich.

**Patentansprüche**

1. Schaltungsanordnung mit einem symmetrisch aufgebauten Abtast-Halte-Verstärker (AHV), bestehend aus einem ersten Transistor (T1a), einem zweiten Transistor (T1b), einem dritten Transistor (T2a) und einem vierten Transistor (T2b), wobei der Kollektor des ersten Transistors (T1a) mit dem Kollektor des dritten Transistors (T2a) zusammengeschaltet ist und die erste Ausgangsklemme (Aa) bildet und der Kollektor des zweiten Transistors (T1b) mit dem Kollektor des vierten Transistors (T2b) zusammengeschaltet ist und die zweite Ausgangsklemme (Ab) bildet, wobei die erste Ausgangsklemme (Aa) über einen ersten Kollektorwiderstand (RCa) an ein erstes Versorgungspotential ($V_{CC}$) geschaltet ist und die zweite Ausgangsklemme (Ab) über einen zweiten Kollektorwiderstand (RCb) ebenfalls an dieses erste Versorgungspotential ($V_{CC}$) geschaltet ist, wobei die erste Ausgangsklemme (Aa) mit den Steuereingang des vierten Transistors (T2b) verbunden ist und die zweite Ausgangsklemme (Ab) mit dem Steuereingang des dritten Transistors (T2a) verbunden ist, wobei die erste und die zweite Ausgangsklemme (Aa, Ab) über eine Haltekapazität (Ch) miteinander verbunden sind, wobei der Emitter des ersten Transistors (T1a) mit dem Emitter des dritten Transistors (T2a) unmittelbar verbunden ist und der Emitter des zweiten Transistors (T1b) mit dem Emitter des vierten Transistors (T2b) unmittelbar verbunden ist, wobei die Emitter des ersten und des dritten Transistors (T1a, T2a) und die Emitter des zweiten und des vierten Transistors (T1b, T2b) über mindestens einen Widerstand (RE, REa, REb) miteinander verbunden sind und über mindestens eine Konstantstromeinprägung (Ik1, Ik1a, Ik1b) an ein zweites Versorgungspotential ($V_{EE}$) geschaltet sind und wobei der Steueranschluß des ersten Transistors (T1a) und der Steueranschluß des zweiten Transistors (T1b) mit einem differentiellen Signal beaufschlagbar sind,

**dadurch gekennzeichnet,** daß die erste Signaleingangsklemme (Ea) den Eingang einer ersten schaltbaren Pegelschiebereinrichtung (PSa) bildet, daß die zweite, für das zum an der ersten Signaleingangsklemme (Ea) eingespeisten Signal komplementäre Signal vorgesehene Signaleingangsklemme (Eb) den Eingang einer zweiten schaltbaren Pegelschiebereinrichtung (PSb) bildet, daß der Ausgang der ersten schaltbaren Pegelschiebereinrichtung (PSa) mit dem Steueranschluß des ersten Transistors (T1a) zusammengeschaltet ist, daß der Ausgang der zweiten schaltbaren Pegelschiebereinrichtung (PSb) mit dem Steueranschluß des zweiten Transistors (T1b) zusammengeschaltet ist und daß zwischen dem Eingangssignal und dem Ausgangssignal dieser steuerbaren Pegelschiebereinrichtungen (PSa, PSb) in Abhängigkeit vom Schaltzustand der Pegelschiebereinrichtungen eine unterschiedliche, jeweils konstante Gleichspannungsdifferenz besteht.

2. Schaltungsanordnung nach Anspruch 1,
**dadurch gekennzeichnet,** daß die Kollektoranschlüsse des ersten und des dritten Transistors (T1a, T2a) nicht unmittelbar die erste Ausgangsklemme (Aa) bilden, sondern an den Steueranschluß eines ersten Impedanzwandlers (T4a) und über den ersten Kollektorwiderstand (RCa) an das erste Versorgungspotential (V$_{CC}$) geschaltet sind, daß die Kollektoranschlüsse des zweiten und des vierten Transistors (T1b, T2b) nicht unmittelbar die zweite Ausgangsklemme (Ab) bilden, sondern an den Steueranschluß eines zweiten Impedanzwandlers (T4b) und über den zweiten Kollektorwiderstand (RCb) an das erste Versorgungspotential (V$_{CC}$) angeschlossen sind, daß der Ausgang des ersten Impedanzwandlers (T4a) die erste Ausgangsklemme (Aa) bildet und daß der Ausgang des zweiten Impedanzwandlers (T4b) die zweite Ausgangsklemme (Ab) bildet.

3. Schaltungsanordnung nach Anspruch 2,
**dadurch gekennzeichnet,** daß der erste und der zweite Impedanzwandler jeweils durch einen siebten bzw. achten Transistor (T4a, T4b) in Emitterfolgerschaltung realisiert ist, wobei der Kollektoranschluß des siebten bzw. achten Transistors (T4a, T4b) jeweils an das erste Versorgungspotential (V$_{CC}$) geschaltet ist und der Emitteranschluß des siebten bzw. achten Transistor (T4a, T4b), der jeweils die erste bzw. zweite Ausgangsklemme (Aa, Ab) der Schaltungsanordnung bildet, jeweils über eine zweite bzw. dritte Konstantstromeinprägung (Ik2a, Ik2b) an das zweite Versorgungspotential (V$_{EE}$) geschaltet ist.

4. Schaltungsanordnung nach Anspruch 3,
**dadurch gekennzeichnet,** daß die zweite Konstantstromeinprägung (Ik2a) über einen ersten Umschalter (T5a, T6a) entweder an den Emitteranschluß des siebten Transistor (T4a) oder an ein Versorgungspotential - beispielsweise das erste Versorgungspotential (V$_{CC}$) - schaltbar ist und daß die dritte Konstantstromeinprägung (Ik2b) über einen zweiten Umschalter (T5b, T6b) entweder an den Emitteranschluß des achten Transistors (T4b) oder an ein Versorgungspotential - beispielsweise das erste Versorgungspotential (V$_{CC}$) - schaltbar ist.

5. Schaltungsanordnung nach einem der Ansprüche 3 oder 4,
**dadurch gekennzeichnet,** daß zwischen dem ersten Versorgungspotential (V$_{CC}$) und dem Kollektoranschluß des siebten bzw. achten Transistors (T4a, T4b) jeweils die steuerbare Strecke eines Transistors (T3a, T3b) geschaltet ist, daß der Steuereingang des am siebten Transistor (T4a) angeschlossenen Transistors (T3a) mit einem vom am Eingang (Eb) der zweiten Pegelschiebereinrichtung (PSb) anliegenden Signal abgeleiteten Signal beaufschlagt ist und daß der Steuereingang des am achten Transistor (T4b) angeschlossenen Transistors (T3b) mit einem vom am Eingang (Ea) der ersten Pegelschiebereinrichtung (PSa) anliegenden Signal abgeleiteten Signal beaufschlagt ist.

6. Schaltungsanordnung nach einem der vorhergehenden Ansprüche,
**dadurch gekennzeichnet,** daß der für das abzutastende Signal vorgesehene Eingang (Ea) der Pegelschiebereinrichtung (PSa) mit dem Steuereingang eines Eingangstransistors (T7a) verbunden ist, daß der Kollektoranschluß des Eingangstransistors (T7a) an das erste Versorgungspotential (V$_{CC}$) geschaltet ist, daß der Emitteranschluß des Eingangstransistors (T7a) über mindestens einen Schiebewiderstand (R1a) sowohl an den Steuereingang eines Ausgangstransistors (T8a), als auch an einen Wechseleingang eines dritten Umschalters (T9a, T10a) geschaltet ist, daß der Emitteranschluß des Eingangstransistors (T7a) außerdem an den anderen Wechseleingang dieses dritten Umschalters (T9a, T10a) geschaltet ist, daß der Zentraleingang dieses dritten Umschalters (T9a, T10a) über eine Konstantstromeinprägung (Ik4a) an das zweite Versorgungspotential (V$_{EE}$) angeschlossen ist, daß der Kollektoranschluß des Ausgangstransistors (T8a) an das erste Versorgungspotential (V$_{CC}$) geschaltet ist, daß der Emitter des Ausgangstransistor (T8a) den Ausgang der ersten Pegelschiebereinrichtung (PSa) bildet und über eine weitere Konstantstromeinprägung (Ik3a) an das zweite Versorgungspotential (V$_{EE}$) angeschlossen ist.

7. Schaltungsanordnung nach einem der vorhergehenden Ansprüche,
**dadurch gekennzeichnet,** daß der Emitteranschluß des ersten Transistors (T1a) unmittelbar mit dem Emitteranschluß des dritten Transistors (T2a), dem Basisanschluß eines neunten Transistors (TBa) und einem Anschluß eines ersten Emitterwiderstandes (REa) zusammengeschaltet ist, daß der Emitteranschluß des zweiten Transistors (T1b) unmittelbar mit dem Emitteranschluß des vierten Transistors (T2b), dem Basisanschluß eines zehnten (TBb) und mit einem Anschluß eines zweiten Emitterwiderstandes (REb) zusammengeschaltet ist, daß die beiden Emitterwiderstände (REa, REb) mit ihrem jeweils anderen Anschluß über eine Konstantstromeinprägung (Ik1) an das zweite Versorgungspotential (V$_{EE}$) geschaltet sind, daß der Emitteranschluß des neunten Transistors (TBa) über die Serienschaltung zweier zusätzlicher Widerstände (RZa, RZb) mit dem Emitteranschluß des zehnten Transistors (TBb) verbunden ist, daß der Schaltungsknoten, der die beiden zusätzlichen Widerstände (RZa, RZb) verbindet, über eine weitere Konstantstromeinprägung (Ik1a) an das zweite Versorgungspotential (V$_{EE}$) geschaltet ist, daß der Kollektoranschluß des neunten Transistors (TBa) über einen Widerstand (RKa) an das erste Versorgungspotential (V$_{CC}$) geschaltet ist und daß der Kollektoranschluß des zehnten Transistors (TBb) ebenfalls über einen Widerstand (RKb) an das erste Versorgungspotential (V$_{CC}$) geschaltet ist.

8. Schaltungsanordnung nach einem der vorhergehenden Ansprüche,
**dadurch gekennzeichnet,** daß das erste Versorgungspotential (V$_{CC}$) jeweils über eine in Durchlaßrichtung geschaltete Diode (TCa, TCb) an den ersten bzw. zweiten Kollektorwiderstand (RCa, RCb) geschaltet ist.

9. Schaltungsanordnung nach Anspruch 8,
**dadurch gekennzeichnet,** daß als Diodenstrecke jeweils ein Transistor (TCa, TCb) vorgesehen ist, dessen Kollektoranschluß mit dem Basisanschluß kurzgeschlossen ist und daß die Emitteranschlüsse dieser Transistoren (TCa, TCb) jeweils mit dem Basisanschluß eines elften Transistors (TDa) bzw. zwölften Transistors (TDb) verbunden sind, daß der Kollektoranschluß des elften Transistors (TDa) und der Kollektoranschluß des zwölften Transistors (TDb) jeweils unmittelbar mit dem ersten Versorgungspotential (V$_{CC}$) beaufschlagt ist, daß der Emitteranschluß des elften Transistors (TDa) über einen Widerstand (RKa) an den Kollektoranschluß des neunten Transistors (TBa) angeschlossen ist und daß der Emitteranschluß des zwölften Transistors (TDb) über einen Widerstand (RKb) an den Kollektoranschluß des zehnten Transistors (TBb) angeschlossen ist.

**Claims**

1. Circuit arrangement having a symmetrically constructed sample-and-hold amplifier (AHV), consisting of a first transistor (T1a), a second transistor (T1b), a third transistor (T2a) and a fourth transistor (T2b), the collector of the first transistor (T1a) being connected together with the collector of the first third transistor (T2a) and forming the first output terminal (Aa) and the collector of the second transistor (T1b) being connected together with the collector of the fourth transistor (T2b) and forming the second output terminal (Ab), the first output terminal (Aa) being connected to a first supply potential (V$_{CC}$) via a first collector resistor (RCa) and the second output terminal (Ab) being likewise connected to this first supply potential (V$_{CC}$) via a second collector resistor (RCb), the first output terminal (Aa) being connected to the control input of the fourth transistor (T2b) and the second output terminal (Ab) being connected to the control input of the third transistor (T2a), the first and the second output terminals (Aa, Ab) being connected to each other via a hold capacitor (Ch), the emitter of the first transistor (T1a) being directly connected to the emitter of the third transistor (T2a) and the emitter of the second transistor (T1b) being directly connected to the emitter of the fourth transistor (T2b), the emitter of the first and of the third transistor (T1a, T2a) and the emitter of the second and of the fourth transistor (T1b, T2b) being connected to each other via at least one resistor (RE, REa, REb) and being connected to a second supply potential (V$_{EE}$) via at least one constant current impressing device (Ik1, Ik1a, Ik1b) and a differential signal being applicable to the control connection of the first transistor (T1a) and the control connection of the second transistor (T1b), characterized in that the first signal input terminal (Ea) forms the input of a first switchable level shifting device (PSa), in that the second signal input terminal (Eb), provided for the signal complementary to the signal applied at the first signal input terminal (Ea), forms the input of a second switchable level shifting device (PSb), in that the output of the first switchable level shifting device (PSa) is connected together with the control connection of the first transistor (T1a), in that the output of the second switchable level shifting device (PSb) is connected together with the control connection of the second transistor (T1b) and in that a different, in each case constant direct current difference exists between the input signal and the output signal of these controllable level shifting devices (PSa, PSb) as a function of the switching state of the level shifting devices.

2. Circuit arrangement according to Claim 1, characterized in that the collector connections of the first and of the third transistor (T1a, T2a) do not directly form the first output terminal (Aa), but are connected to the control connection of a first impedance converter (T4a) and to the first supply potential ($V_{CC}$) via the first collector resistor (RCa), in that the collector connections of the second and of the fourth transistor (T1b, T2b) do not directly form the second output terminal (Ab), but are connected to the control connection of a second impedance converter (T4b) and to the first supply potential ($V_{CC}$) via the second collector resistor (RCb), in that the output of the first impedance converter (T4a) forms the first output terminal (Aa) and in that the output of the second impedance converter (T4b) forms the second output terminal (Ab).

3. Circuit arrangement according to Claim 2, characterized in that the first and the second impedance converter are in each case implemented by a seventh and eighth transistor (T4a, T4b), respectively, in emitter-follower circuit, the collector connection of the seventh and eighth transistor (T4a, T4b), respectively, being in each case connected to the first supply potential ($V_{CC}$),and the emitter connection of the seventh and eighth transistor (T4a, T4b), respectively, which respectively form the first and second output terminal (Aa, Ab), respectively, of the circuit arrangement being in each case connected to the second supply potential ($V_{EE}$) via a second and third constant current impressing device (Ik2a, Ik2b), respectively.

4. Circuit arrangement according to Claim 3, characterized in that the second constant current impressing device (Ik2a) can be connected via a first changeover switch (T5a, T6a) either to the emitter connection of the seventh transistor (T4a) or to a supply potential - for example, the first supply potential ($V_{CC}$) - and in that the third constant current impressing device (Ik2b) can be connected via a second changeover switch (T5b, T6b) either to the emitter connection of the eighth transistor (T4b) or to a supply potential - for example, the first supply potential ($V_{CC}$).

5. Circuit arrangement according to one of Claims 3 or 4, characterized in that in each case the controllable junction of a transistor (T3a, T3b) is connected between the first supply potential ($V_{CC}$) and the collector connection of the seventh and eighth transistor (T4a, T4b), respectively, in that a signal derived from the signal present at the input (Eb) of the second level shifting device (PSb) is applied to the control input of the transistor (T3a) connected to the seventh transistor (T4a), and in that a signal derived from the signal present at the input (Ea) of the first level shifting device (PSa) is applied to the control input of the transistor (T3b) connected to the eighth transistor (T4b).

6. Circuit arrangement according to one of the preceding claims, characterized in that the input (Ea) of the level shifting device (PSa) and provided for the signal to be sampled is connected to the control input of an input transistor (T7a), in that the collector connection of the input transistor (T7a) is connected to the first supply potential ($V_{CC}$), in that the emitter connection of the input transistor (T7a) is connected via at least one slide resistor (R1a) both to the control input of an output transistor (T8a) and to a changing input of a third changeover switch (T9a, T10a), in that the emitter connection of the input transistor (T7a) is connected to the other changing input of this third changeover switch (T9a, T10a), in that the central input of this third changeover switch (T9a, T10a) is connected to the second supply potential ($V_{EE}$) via a constant current impressing device (Ik4a), in that the collector connection of the output transistor (T8a) is connected to the first supply potential ($V_{CC}$), and in that the emitter of the output transistor (T8a) forms the output of the first level shifting device (PSa) and is connected to the second supply potential ($V_{EE}$) via a further constant current impressing device (Ik3a).

7. Circuit arrangement according to one of the preceding claims, characterized in that the emitter connection of the first transistor (T1a) is directly connected together with the emitter connection of the third transistor (T2a), the base connection of a ninth transistor (TBa) and a connection of a first emitter resistor (REa), in that the emitter connection of the second transistor (T1b) is directly connected together with the emitter connection of the fourth transistor (T2b), the base connection of a tenth (TBb) and with a connection of a second emitter resistor (REb), in that the in each case other connection of both emitter resistors (REa, REb) is connected to the second supply potential (V$_{EE}$) via a constant current impressing device (lk1), in that the emitter connection of the ninth transistor (TBa) is connected to the emitter connection of the tenth transistor (TBb) via two additional resistors (RZa, RZb) connected in series, in that the circuit node connecting both additional resistors (RZa, RZb) is connected to the second supply potential (V$_{EE}$) via a further constant current impressing device (lk1a), in that the collector connection of the ninth transistor (TBa) is connected to the first supply potential (V$_{CC}$) via a resistor (RKa), and in that the collector connection of the tenth transistor (TBb) is likewise connected to the first supply potential (V$_{CC}$) via a resistor (RKb).

8. Circuit arrangement according to one of the preceding claims, characterized in that the first supply potential (V$_{CC}$) is connected to the first and second collector resistor (RCa, RCb), respectively, via a diode (TCa, TCb) connected in the forward direction.

9. Circuit arrangement according to Claim 8, characterized in that there is provided in each case as diode junction a transistor (TCa, TCb), whose collector connection is short-circuited with the base connection and that the emitter connections of these transistors (TCa, TCb) are in each case connected to the base connection of an eleventh transistor (TDa) and a twelfth transistor (TDb), respectively, in that the first supply potential (V$_{CC}$) is directly applied in each case to the collector connection of the eleventh transistor (TDa) and to the collector connection of the twelfth transistor (TDb), in that the emitter connection of the eleventh transistor (TDa) is connected to the collector connection of the ninth transistor (TBa) via a resistor (RKa), and in that the emitter connection of the twelfth transistor (TDb) is connected to the collector connection of the tenth transistor (TBb) via a resistor (RKb).

**Revendications**

1. Circuit qui est constitué d'un amplificateur d'échantillonnage-blocage (AHV) de structure symétrique, constitué d'un premier transistor (T1a), d'un second transistor (T1b), d'un troisième transistor (T2a) et d'un quatrième transistor (T2b), dans lequel le collecteur du premier transistor (T1a) est interconnecté au collecteur du troisième transistor (T2a) et forme la première borne de sortie (Aa), dans lequel le collecteur du second transistor (T1b) est interconnecté au collecteur du quatrième transistor (T2b) et forme la seconde borne de sortie (Ab), dans lequel la première borne de sortie (Aa) est mise à un premier potentiel d'alimentation (V$_{CC}$) par l'intermédiaire d'une première résistance de collecteur (RCa), dans lequel la seconde borne de sortie (Ab) est également mise à ce premier potentiel d'alimentation (V$_{CC}$) par l'intermédiaire d'une seconde résistance de collecteur (RCb), dans lequel la première borne de sortie (Aa) est connectée à l'entrée de commande du quatrième transistor (T2b), dans lequel la seconde borne de sortie (Ab) est connectée à l'entrée de commande du troisième transistor (T2a), dans lequel les première et seconde bornes de sortie (Aa, Ab) sont reliées entre elles par l'intermédiaire d'une capacité de blocage (Ch), dans lequel l'émetteur du premier transistor (T1a) est raccordé directement à l'émetteur du troisième transistor (T2a), dans lequel l'émetteur du second transistor (T1b) est raccordé directement à l'émetteur du quatrième transistor (T2b), dans lequel les émetteurs des premier et troisième transistors (T1a, T2a) et les émetteurs des second et quatrième transistors (T1b, T2b) sont reliés entre eux par l'intermédiaire d'au moins une résistance (RE, REa, REb) et sont mis à un second potentiel d'alimentation (V$_{EE}$) par l'intermédiaire d'au moins une source de courant constant (lk1, lk1a, lk1b), dans lequel à la borne de commande du premier transistor (T1a) et à la borne de commande du second transistor (T1b) peut être appliqué un signal différentiel, et qui est caractérisé en ce que la première borne d'entrée de signal (Ea) forme l'entrée d'un premier dispositif commutable à décalage de niveau (PSa), que la seconde borne d'entrée de signal (Eb), qui est prévue pour le signal complémentaire du signal sur la première borne d'entrée de signal (Ea), forme l'entrée d'un second dispositif commutable à décalage de niveau (PSb), que la sortie du premier dispositif commutable à décalage de niveau (PSa) est interconnectée à la borne de commande du premier transistor (T1a), que la sortie du second dispositif commutable à décalage de niveau (PSb) est interconnectée à la borne de commande du second transistor (T1b) et qu'entre le signal d'entrée et le signal de sortie de ces dispositifs commandables à décalage de niveau (PSa, PSb) il existe une différence de tension continue respectivement constante et différente dépendant de l'état de commutation des dispositifs à décalage de niveau.

2. Circuit suivant la revendication 1, caractérisé en ce que les bornes de collecteur des premier et troisième transistors (T1a, T2a) ne forment pas directement la première borne de sortie (Aa), mais sont connectées à la borne de commande d'un premier convertisseur d'impédance (T4a) et, sont mises au premier potentiel d'alimentation ($V_{CC}$) par l'intermédiaire de la première résistance de collecteur (RCa), que les bornes de collecteur du second et du quatrième transistor (T1b, T2b) ne forment pas directement la seconde borne de sortie (Ab), mais sont raccordées à la borne de commande d'un second convertisseur d'impédance (T4b) et, sont mises au premier potentiel d'alimentation ($V_{CC}$) par l'intermédiaire de la seconde résistance de collecteur (RCb), que la sortie du premier convertisseur d'impédance (T4a) forme la première borne de sortie (Aa) et que la sortie du second convertisseur d'impédance (T4b) forme la seconde borne de sortie (Ab).

3. Circuit suivant la revendication 2, caractérisé en ce que le premier et le deuxième convertisseur d'impédance sont constitués respectivement d'un septième et d'un huitième transistor (T4a, T4b) en émetteur suiveur, les bornes de collecteur du septième et du huitième transistor (T4a, T4b) étant chacune raccordée au premier potentiel d'alimentation ($V_{CC}$), tandis que les bornes d'émetteur du septième et du huitième transistor (T4a, T4b), qui forment respectivement la première et la seconde borne de sortie (Aa, Ab) du circuit, sont mises au second potentiel d'alimentation ($V_{EE}$), par l'intermédiaire d'une seconde et d'une troisième source de courant constant (Ik2a, Ik2b).

4. Circuit suivant la revendication 3, caractérisé en ce que la seconde source de courant constant (Ik2a) peut être reliée par l'intermédiaire d'un premier commutateur (T5a, T6a) soit à la borne d'émetteur du septième transistor (T4a), soit à un potentiel d'alimentation - par exemple le premier potentiel d'alimentation ($V_{CC}$) - et que la troisème source de courant constant (Ik2b) peut être reliée par l'intermédiaire d'un second commutateur (T5b, T6b), soit à la borne d'émetteur du huitième transistor (T4b) soit à un potentiel d'alimentation - par exemple le premier potentiel d'alimentation ($V_{CC}$).

5. Circuit suivant l'une des revendications 3 ou 4, caractérisé en ce que l'accès commandable d'un transistor (T3a, T3b) est branché entre le premier potentiel d'alimentation ($V_{CC}$) et la borne de collecteur du septième et du huitième transistor (T4a, T4b), qu'à l'entrée de commande du transistor (T3a) connectée au septième transistor (T4a) est appliqué un signal qui est dérivé du signal appliqué à l'entrée (Ab) du second dispositif à décalage de niveau (PSb), et qu'à l'entrée de commande du transistor (T3b) connectée au huitième transistor (T4b) est appliqué un signal dérivé du signal appliqué à l'entrée (Ea) du premier dispositif à décalage de niveau (PSa).

6. Circuit suivant l'une des revendications précédentes, caractérisé en ce que l'entrée (Ea), prévue pour le signal devant être échantillonné, du dispositif à décalage de niveau (PSa) est reliée à l'entrée de commande d'un transistor d'entrée (T7a), que la borne de collecteur du transistor d'entrée (T7a) est reliée au premier potentiel d'alimentation ($V_{CC}$), que la borne d'émetteur du transistor d'entrée (T7a) est connectée par l'intermédiaire d'au moins une résistance de décalage (R1a) à la fois à l'entrée de commande d'un transistor de sortie (T8a) et à une entrée de changement d'un troisième commutateur (T9a, T10a), que la borne d'émetteur du transistor d'entrée (T7a) est en outre connectée à l'autre entrée de changement de ce troisième commutateur (T9a, T10a), qu'à l'entrée centrale de ce troisième commutateur (T9a, T10a) est appliqué par l'intermédiaire d'une source de courant constant (Ik4a) le second potentiel d'alimentation ($V_{EE}$), qu'à la borne de collecteur du transistor de sortie (T8a) est appliqué le premier potentiel d'alimentation ($V_{CC}$), que l'émetteur du transistor de sortie (T8a) forme la sortie du premier dispositif à décalage de niveau (PSa) et est reliée, par l'intermédiaire d'une autre source de courant constant (Ik3a) au second potentiel d'alimentation ($V_{EE}$).

7. Circuit suivant l'une des revendications précédentes, caractérisé en ce que la borne d'émetteur du premier transistor (T1a) est interconnectée directement à la borne d'émetteur du troisième transistor (T2a), à la borne de base d'un neuvième transistor (TBa) et à une borne d'une première résistance d'émetteur (REa), que la borne d'émetteur du second transistor (T1b) est interconnectée directement à la borne d'émetteur du quatrième transistor (T2b), à la borne de base d'un dixième transistor (TBb) et à une borne d'une seconde résistance d'émetteur (REb), que les deux résistances d'émetteur (REa, REb) sont mises, par leur autre borne respective, au second potentiel d'alimentation ($V_{EE}$) par l'intermédiaire d'une source de courant constant (Ik1), que la borne d'émetteur du neuvième transistor (TBa) est reliée par l'intermédiaire du circuit série formé de deux résistances supplémentaires (RZa, RZb), à la borne d'émetteur du dixième transistor (TBb), que le noeud du circuit, qui relie les deux résistances supplémentaires (RZa, RZb), est mis par l'intermédiaire d'une autre source de courant constant (Ik1a) au second potentiel d'alimentation ($V_{EE}$), que la borne de collecteur du neuvième transistor (TBa) est reliée par l'intermédiaire d'une résistance (RKa) au premier potentiel d'alimentation ($V_{CC}$), et que la borne de collecteur du dixième transistor (TBb) est également mise, par l'intermédiaire d'une résistance (RKb), au premier potentiel d'alimentation ($V_{CC}$).

8. Circuit suivant l'une des revendications précédentes, caractérisé en ce que le premier potentiel d'alimentation ($V_{CC}$) est connecté respectivement par l'intermédiaire d'une diode (TCa, TCb), branchée dans le sens passant, à la première et à la seconde résistance de collecteur (RCa, RCb).

9. Circuit suivant la revendication 8, caractérisé par le fait que comme section formant diode il est prévu respectivement un transistor (TCa, TCb), dont la borne de collecteur est court-circuitée à la borne de base et que les bornes d'émetteur de ces transistors (TCa, TCb) sont reliées respectivement à la borne de base d'un onzième transistor (TDa) et d'un douzième transistor (TDb), que la borne de collecteur du onzième transistor (TDa) et la borne de collecteur du douzième transistor (TDb) sont alimentées chacune directement par le premier potentiel d'alimentation ($V_{CC}$), que la borne d'émetteur du onzième transistor (TDa) est reliée par l'intermédiaire d'une résistance (RKa) à la borne de collecteur du neuvième transistor (TBa), et que la borne d'émetteur du douzième transistor (TDb) est reliée par l'intermédiaire d'une résistance (RKb) à la borne de collecteur du dixième transistor (TBb).

EP 0 394 506 B1

## FIG 1

## FIG 2

## FIG 3

15

# FIG 4

## FIG 5

## FIG 6

# FIG 7

FIG 8

EP 0 394 506 B1